Europäisches Patentamt

European Patent Office

Office européen des brevets

(11) Veröffentlichungsnummer: **0 306 790**
**A2**

## EUROPÄISCHE PATENTANMELDUNG

(21) Anmeldenummer: 88114026.3

(22) Anmeldetag: 27.08.88

(51) Int. Cl.⁴: **G01N 23/225 , G02B 5/10**

(30) Priorität: 05.09.87 DE 3729846

(43) Veröffentlichungstag der Anmeldung:
15.03.89 Patentblatt 89/11

(84) Benannte Vertragsstaaten:
**DE FR IT**

(71) Anmelder: **Firma Carl Zeiss**

**D-7920 Heidenheim (Brenz)(DE)**

(72) Erfinder: **Schäfer, Norbert, Dipl.-Ing.**
**Kantstrasse 1**
**D-7087 Essingen(DE)**
Erfinder: **Eppli, Bernd, Dipl.-Ing.**
**Schumannstrasse 11**
**D-7923 Königsbronn(DE)**
Erfinder: **Weimer, Eugen, Dr. Dipl.-Phys.**
**Schradenbergstrasse 2**
**D-7087 Essingen(DE)**
Erfinder: **Rossow, Eberhard, Ing.(grad)**
**Lenzhalde 40**
**D-7082 Oberkochen(DE)**
Erfinder: **Gross, Herbert, Dipl.-Phys.**
**Schillerstrasse 28**
**D-7087 Essingen(DE)**

(54) **Kathodolumineszenzdetektor.**

(57) Es wird ein Detektor beschrieben, der aus einem elliptischen Hohlspiegel (12h) und einem Rohr (13r) mit reflektierender Innenfläche zur Weiterleitung des Lichtes besteht. Das Vakuumfenster (13v) sitzt am äußeren Ende des Rohres (13r) unmittelbar vor dem Empfänger.

Fig. 1

EP 0 306 790 A2

# Kathodolumineszenzdetektor

Die vorliegende Erfindung betrifft einen Kathodolumineszenzdetektor nach dem Oberbegriff des Anspruches 1. Derartige Detektoren werden vorzugsweise in Rasterelektronenmikroskopen (REM bzw. SEM für scanning electron microscope) verwendet.

In einem Rasterelektronenmikroskop wird die zu untersuchende Probe mit einem auf die Probe fokussierten Elektronenstrahl mäanderförmig abgetastet Dabei kommt es zu verschiedenen Wechselwirkungen an der Probe. Unter Kathodolumineszenz versteht man die Emission von Lichtquanten in sichtbaren oder benachbarten Spektralgebieten durch den Elektronenstrahl. Mit Hilfe geeigneter Detektoren und einem Bildaufbau entsprechend der Abtastbewegung des Elektronenstrahles werden z.B. auf einem Monitor Bilder erzeugt, die der Lichtemission der Probe entsprechen. Dabei können bestimmte Spektralgebiete z.B. durch Filter ausgesondert werden. Häufig werden gleichzeitig auch andere Wechselwirkungen zwischen Elektronenstrahl und Probe mit zusätzlichen Detektoren untersucht, z.B. Sekundärelektronen.

Aus der DD-PS 207 994 ist ein Kathodolumineszenzdetektor bekannt, bei dem ein Paraboloidspiegel zwischen dem Polschuh der letzten elektronenoptischen Linse und der Probe angeordnet ist. Der Paraboloidspiegel hat eine Bohrung für den Elektronenstrahl und reflektiert das von der in seinem Brennpunkt liegenden Probe ausgehende Licht als Parallellichtbündel auf eine Linse, die es auf einen photoelektrischen Empfänger konzentriert. Ein Nachteil dieser Anordnung ist, daß für eine gute Lichtausbeute das Paraboloid verhältnismäßig groß sein und daher die Probe zum Elektronenstrahl geneigt werden muß. Infolgedessen sind die Abmessungen der Probe beschränkt

Aus einer Veröffentlichung von E.N.Hörl (Beiträge elektronen mikroskopische Direktabbildung von Oberflächen 8, 369 (1975)) ist ein Kathodolumineszenzdetektor bekannt, bei dem die Probe in dem einen Brennpunkt eines elliptischen Spiegels angeordnet ist und bei dem für eine möglichst gute Lichtausbeute zusätzlich ein parabolischer Spiegel so angeordnet ist, daß sein Brennpunkt im zweiten Brennpunkt der Ellipse liegt. Hier muß die Probe zwar nicht gegenüber dem Elektronenstrahl geneigt werden, ihre Größe ist jedoch durch den Paraboloidspiegel ebenfalls begrenzt. Aus dieser Veröffentlichung ist auch die Verwendung eines Lichtleiters als Vakuumfenster bekannt.

Der vorliegenden Erfindung liegt daher die Aufgabe zugrunde, einen Kathodolumineszenzdetektor zu schaffen, der eine gute Lichtausbeute hat und trotzdem die Probengröße nicht begrenzt. Außerdem soll der Kathodolumineszenzdetektor gleichzeitig mit anderen Detektoren verwendet und leicht aus dem Strahlengang entfernt werden können.

Die gestellte Aufgabe wird bei einem Kathodolumineszenzdetektor mit einem Hohlspiegel dadurch gelöst, daß der Hohlspiegel an einem Rohr befestigt ist, dessen Innenfläche reflektierend ausgebildet ist, und daß das Vakuumfenster in diesem Rohr oder an dessen zum Empfänger gewandten Ende angeordnet ist.

In einer vorteilhaften Ausführungsform besteht das Vakuumfenster aus einem zylinderförmigen Glas- oder Kunststoffteil, welches mindestens teilweise im reflektierenden Rohr angeordnet ist. Es wird über einen in Richtung der Rohrachse gepreßten Dichtungsring mit dem Rohr vakuumdicht verbunden.

Es ist besonders vorteilhaft, das Vakuumfenster am äußeren Ende des Rohres so anzuordnen, daß das Fenster des Empfängers unmittelbar dahinter liegt. Auf diese Weise werden nicht nur Reflexionsverluste durch einen Luftzwischenraum zwischen Vakuumfenster und Fenster des Empfängers vermieden, sondern das Vakuumfenster wird auch so weit wie möglich von der Probe entfernt angeordnet, so daß die Erzeugung von Lumineszenzlicht in ihm durch an der Probe rückgestreute Elektronen sehr gering wird. Würde man das Rohr durch einen zylinderförmigen Lichtleitstab ersetzen, das zugleich als Vakuumfenster ausgebildet sein könnte, dann würde bei Proben mit geringer Kathodolumineszenz deren Lumineszenzstrahlung zu stark von der durch rückgestreute Elektronen im Lichtleitstab erzeugten Lumineszenzstrahlung überlagert.

In einer weiteren vorteilhaften Ausführungsform sitzt der Hohlspiegel in einer Fassung, die reproduzierbar auf das reflektierende Rohr aufsteckbar ist. Dadurch können mit dem Detektor auch Messungen ohne den Hohlspiegel durchgeführt werden, was bei Proben mit starker Kathodoluminzeszenz möglich ist und den Vorteil hat, daß mehr Platz für weitere Detektoren bleibt.

In einer besonders vorteilhaften Ausführungsform ist das reflektierende Rohr mit dem Empfänger in Richtung der Rohrachse verschiebbar und vakuumdicht in der Wand der Probenkammer gelagert und es sind Mittel vorhanden, welche eine reproduzierbare Stellung des inneren Endes vom Rohr im eingeschobenen Zustand bewirken. Gegebenenfalls zusammen mit der reproduzierbar aufsteckbaren Fassung des Hohlspiegels ist dadurch die Möglichkeit gegeben, ein und dieselbe Stelle einer Probe auch zeitlich hintereinander mit verschiedenen Detektoren zu untersuchen.

Weitere vorteilhafte Ausführungsformen der Erfindung gehen aus den Unteransprüchen und aus den Erläuterungen zu den Figuren hervor.

Die Erfindung wird im folgenden anhand eines in den Figuren 1 bis 2 dargestellten Ausführungsbeispiels näher erläutert. Dabei zeigen

Fig. 1 einen Schnitt durch den Detektor und

Fig. 2 einen Schnitt durch den Hohlspiegel mit Fassung und Anfang des Rohres in vergrößertem Maßstab.

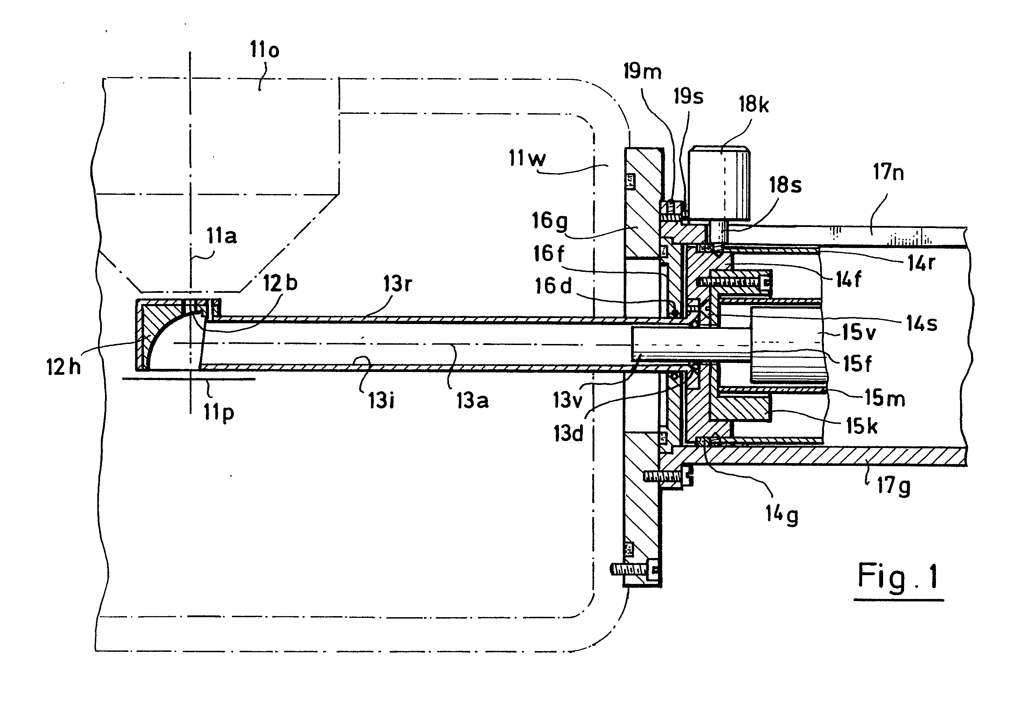

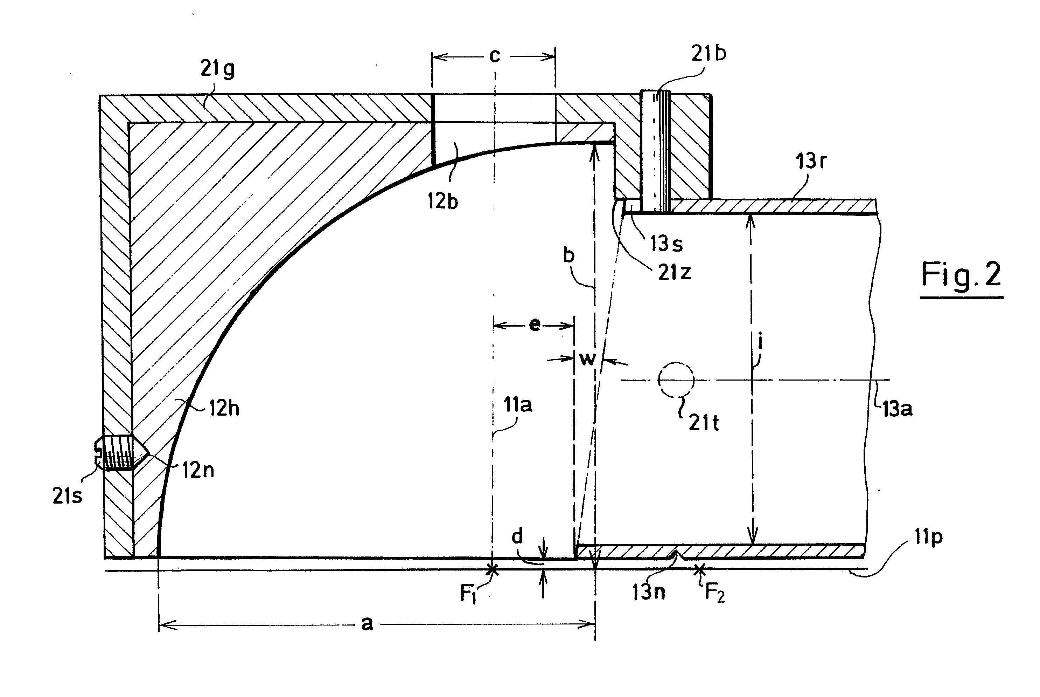

In Figur 1 ist mit (11p) eine Probe, mit (11o) die letzte elektronenoptische Linse, mit (11a) die Mittelachse des Elektronenstrahls und mit (11w) die Wand der Probenkammer eines Rasterelektronenmikroskopes bezeichnet. Zwischen der Probe (11p) und der elektronenoptischen Linse (11o) befindet sich der Hohlspiegel (12h) mit der Bohrung (12b) für den Elektronenstrahl, welcher auf die Probe (11p) auftrifft und diese mäanderförmig abtastet. Der das von der Probe emittierte Licht sammelnde Hohlspiegel (12h) ist, wie weiter unten mit Figur 2 näher beschrieben, mit dem Rohr (13r) verbunden, welches durch die Wand (11w) der Probenkammer geht. Die Innenseite (13i) des Rohres (13r), das vorzugsweise aus Aluminium ist, ist so gut poliert, daß sie das vom Hohlspiegel (12h) gesammelte und in das Rohr reflektierte Licht ebenso wie das direkt in das Rohr emittierte Licht durch Reflexionen weiter leitet bis es in das Vakuumfenster (13v) eintritt. Letzteres ist aus Glas oder Kunststoff und hat die Form eines Zylinders. Es ist über den Dichtungsring (13d) mit dem Rohr (13r) verbunden. Dieser Dichtungsring (13d) sitzt auf einer konischen Fläche am Ende des Rohres. Er wird durch den Flansch (14f) und Schrauben (14s) so in Richtung der Rohrachse (13a) gedrückt, daß eine vakuumdichte Verbindung zwischen dem zylinderförmigen Vakuumfenster (13v) und dem Rohr (13r) hergestellt wird. Innerhalb des Vakuumfensters (13v) trifft das Licht auf die zylinderförmige Außenfläche überwiegend unter einem Winkel, der größer ist als der Grenzwinkel der Totalreflexion, so daß keine Verspiegelung dieser Außenfläche notwendig ist. Unmittelbar an das Ende des Vakuumfensters (13v) wird das Fenster (15f) des Vervielfachers (15v) durch eine (nicht gezeichnete) federnde Halterung des Verfielfachersockels gedrückt, so daß infolge der guten Planheit der beteiligten Flächen nur geringe Reflexionsverluste beim Übertritt entstehen.

Selbstverständlich kann der Vervielfacher durch einen anderen geeigneten Empfänger ersetzt werden. Ebenso ist es auch möglich, zwischen Vakuumfenster (13v) und Vervielfacher (15v) Filter oder einen Monochromator zum Ausblenden bestimmter Spektralbereiche anzuordnen. Schließlich ist auch der Ersatz des Empfängers durch ein Diodenzeilenspektrometer möglich, wobei dessen Anschluß über einen flexiblen Lichtleiter, der unmittelbar an das Vakuumfenster angesetzt wird, besonders vorteilhaft ist.

Das Rohr (13r) ist über die Dichtung (16d) mit dem Flansch (16f) vakuumdicht verbunden und in Richtung seiner Achse (13a) in der Dichtung (16d) verschiebbar. Diese Verschiebung wird außerdem geführt und begrenzt durch das Gehäuse (17g), in dem das Rohr (14r) verschiebbar angeordnet ist, welches über den Flansch (14f) mit dem Rohr (13r) verbunden ist. Die exakte Führung des Rohres (14r) im Gehäuse (17g) erfolgt durch Gleitringe (14g). Die Verschiebung des Hohlspiegels (12h) in den und aus dem Strahlengang erfolgt mit dem Knopf (18k), dessen Stift (18s) durch die Nut (17n) des Gehäuses (17g) geht und in den Flansch (14f) eingeschraubt ist. Durch den Stift (18s) in der Nut (17n) werden zugleich Drehbewegungen des Rohres (13r) um seine Achse (13a) verhindert. Mit der Schraube (19s) am Gehäuse (17g) läßt sich die Endposition des in den Strahlengang eingeschobenen Detektors justieren und mit der Madenschraube (19m) fixieren. Im Flansch (14f) sitzt außerdem ein Kunststoffteil (15k) und der Mu-Metallabschirmbecher (15m) für den Vervielfacher (15v).

Die gesamte Einrichtung ist auf dem Flansch (16g) montiert, der auf eine entsprechende Öffnung in der Wand (11w) der Probenkammer aufgesetzt bzw. abgenommen werden kann. Dieser Flansch kann mit weiteren bekannten Justiereinrichtungen versehen sein.

In Figur 2 ist der Kopf des Detektors in vergrößertem Maßstab dargestellt. Der Hohlspiegel (12h) sitzt in einem Gehäuse (21g) und wird in diesem durch Schrauben (21s) gehalten, welche in Nuten (12n) des Hohlspiegels eingreifen. Das Gehäuse (21g) hat eine Bohrung (21z), welche fast einen ganzen Zylinderumfang umfaßt und mit welcher es auf das Rohr (13r) aufgesteckt wird, wobei ein Bolzen (21b) im Gehäuse (21g) in den im Rohr (13r) eingefrästen Schlitz (13s) eingreift und dadurch das Gehäuse (21g) in eine reproduzierbare Position zum Rohr (13r) bringt. Das Gehäuse (21g) wird außerdem durch Schrauben (21t) fixiert, die in eine Nut (13n) im Rohr (13r) eingreifen.

In der Figur 2 sind außerdem diejenigen Strekken und Winkel bezeichnet, für welche im Anspruch 10 Werte für ein besonders vorteilhaftes Dimensionierungsbeispiel angegeben sind. Der Hohlspiegel (12h) ist ein Rotationsellipsoid, dessen Brennpunkte F1 und F2 auf der Probenoberfläche (11p) liegen. Der Durchmesser c des Loches (12b) kann bei starken Vergrößerungen kleiner gemacht werden, wodurch der Wirkungsgrad des Detektors verbessert wird. Außerdem kann die Achse (13a) des Rohres (13r) zur großen Halbachse a des Rotationsellipsoides einen geringen Winkel bilden, so daß nur das vordere Teil mit dem Hohlspiegel (12h) der Probe (11p) so nah wie notwendig kommt.

## Ansprüche

1. Kathodolumineszenzdetektor mit einem sphärischen oder asphärischen Hohlspiegel (12h), einem Vakuumfenster (13v) aus Glas oder Kunststoff und mit einem photoelektrischen Empfänger (15v), dadurch gekennzeichnet, daß der Hohlspiegel (12h) an einem Rohr (13r) befestigt ist, dessen Innenfläche (13i) reflektierend ausgebildet ist, und daß das Vakuumfenster (13v) in diesem Rohr (13r) oder an dessen zum Empfänger (15v) gewandten Ende angeordnet ist.

2. Detektor nach Anspruch 1, dadurch gekennzeichnet, daß das Vakuumfenster (13v) aus einem zylinderförmigen Glas- oder Kunststoffteil besteht, welches mindestens teilweise im Rohr (13r) angeordnet ist und über einen in Richtung zur Rohrachse (13a) gepreßten Dichtungsring (13d) mit dem Rohr (13r) vakuumdicht verbunden ist.

3. Detektor nach Anspruch 1 oder 2, dadurch gekennzeichnet, daß das Fenster (15f) des Empfängers (15v) unmittelbar hinter dem Vakuumfenster (13v) angeordnet ist.

4. Detektor nach einem der Ansprüche 1 bis 3, dadurch gekennzeichnet, daß der Hohlspiegel (12h) in einem Gehäuse (21g) sitzt, welches reproduzierbar auf das Rohr (13r) aufsteckbar ist.

5. Detektor nach einem der Ansprüche 1 bis 4, dadurch gekennzeichnet, daß das Rohr (13r) mit dem Empfänger (15v) in Richtung der Rohrachse (13a) vakuumdicht verschiebbar in der Wand (11w) der Probenkammer angeordnet ist und daß Mittel für eine reproduzierbare Stellung des inneren Endes des Rohres (13r) im eingeschobenen Zustand vorgesehen sind.

6. Detektor nach einem der Ansprüche 1 bis 5, dadurch gekennzeichnet, daß das Rohr (13r) aus Aluminium ist.

7. Detektor nach einem der Ansprüche 1 bis 6, dadurch gekennzeichnet, daß der Hohlspiegel (12h) aus Aluminium ist oder eine reflektierende Schicht aus Aluminium hat.

8. Detektor nach einem der Ansprüche 1 bis 7, dadurch gekennzeichnet, daß zwischen dem Vakuumfenster (13v) und dem Empfänger (15v) ein Filter oder ein Monochromator angeordnet ist.

9. Detektor nach einem der Ansprüche 1 bis 8, dadurch gekennzeichnet, daß der Hohlspiegel (12h) ein Rotationsellipsoid ist, dessen Quotient große Halbachse a / kleine Halbachse b im Bereich von 1,01 bis 1,05 liegt, wobei die große Halbachse a in der Probenebene (11p) liegt und die Rotationsachse ist.

10. Detektor nach Anspruch 9, gekennzeichnet durch folgende Abmessungen (Fig. 2):

a = 18,5 mm
b = 18,0 mm
c = 5 mm
d = 0,5 mm
e = 3,5 mm
i = 14 mm
w = 12°

Fig. 1

Fig.2

EP 0 306 790 A2